# EUROPEAN PATENT APPLICATION

(11) **EP 1 830 385 A1**
(43) Date of publication of application: **05.09.2007**
(21) Application number: 06004134.0
(22) Date of filing: 01.03.2006
(51) Int. Cl.: H01J 37/304

(54) **Ion beam apparatus and method for aligning same**

(71) Applicant: ICT Integrated Circuit Testing Gesellschaft für Halbleiterprüftechnik mbH, 85551 Heimstetten (DE)
(72) Inventor: Jasinski, Thomas, 81245 Munich (DE); Banzhof, Helmut, 72793 Pfullingen (DE); Frosien, Jürgen, 85521 Riemerling (DE)
(74) Representative: Zimmermann, Gerd Heinrich

(57) **Abstract**

An ion beam apparatus (100) is provided, the ion beam apparatus comprising a movable ion source (110), a condenser lens (120), an aperture (130), and a scanning unit (160) disposed between the condenser lens (120) and the aperture (130), said scanning unit (160) being adapted to scan an ion beam (10) across the aperture (130). Furthermore, a method for aligning components of an ion beam apparatus is provided, comprising the steps of: producing an ion beam (10) by means of an ion source (110), producing a first image (610) of a beam cross section of the ion beam (10) at a first voltage (U_{c1}) of a condenser lens (120), producing a second image (620) of the beam cross section of the ion beam (10) at a second voltage (U_{c2}) of the condenser lens (120), and positioning the ion source (110) so that the centers (P1, P2) of the first and second images (610, 620) coincide.

## Description

### FIELD OF THE INVENTION

The invention relates to an ion beam apparatus, especially an ion beam apparatus, and a method for aligning same, especially for aligning optical components as an ion source, a condenser lens, an aperture, and an objective lens with respect to each other and to the optical axis of the ion beam apparatus.

### BACKGROUND OF THE INVENTION

An essential criterion for the assessment of the performance capability of an ion beam apparatus is the probe current available on the sample. The probe current available on the sample depends on the final aperture, the probe diameter and the beam directionality of the ion source, wherein the available probe current depends linear on the beam directionality. However, the maximum beam directionality of the source can only be used when the source is positioned on the optical axis of the particle beam apparatus. With conventional ion sources, this ideal situation can be achieved only approximately. Typically, optical components like the ion source, the condenser lens, apertures as well as the objective lens are misaligned with respect to each other and/or with respect to the optical axis. Therefore, performance of the ion beam apparatus is lost.

Furthermore, the ion sources have to be exchanged for replacement or maintenance reasons. Especially in focused ion beam systems, source replacement is a frequent task since the material reservoirs of the ion sources are consumed during operation of the ion beam apparatus. Of course, the components of the apparatus, at least the source, have to be again aligned after source replacement.

Conventional methods for aligning optical components of an ion beam apparatus are typically of iterative nature. For example, the source and aperture are shifted on the straight line through the centers of the condenser lens and objective lens, respectively. This is done iteratively and requires several iterations so that this conventional method is relatively time consuming.

An alternative method is described in US 5,969,355 using a monitoring aperture which measures the electric current of an ion beam. Furthermore, a Faraday cup is used to determine the electric current of the ion beam at the sample position. The correct alignment of the optical components is indicated by a minimum current value at the monitoring aperture and a maximum current value at the Faraday cup. However, also the method according to US 5,969,355 is relatively time consuming and requires considerable design efforts since the monitoring aperture and the Faraday cup have to be integrated in an existing system.

Therefore, it is an object of the present invention to provide an improved alignment method for an ion beam apparatus and an improved ion beam apparatus.

### SUMMARY OF THE INVENTION

This object is solved by an ion beam apparatus according to claim 1 and an alignment method according to claim 10. Further advantages, features, aspects and details of the invention are evident from the dependent claims, the description and the accompanying drawings.

According to a first aspect of the present invention an ion beam apparatus is provided. The ion beam apparatus includes an emitter which is positionably disposed within the ion beam apparatus. Furthermore, the ion beam apparatus includes a condenser lens, an aperture, and a scan deflector located downstream the condenser lens and upstream the aperture. The scan deflector is arranged for scanning an ion beam across the aperture.

An ion beam apparatus according to the above-described aspect of the present invention is adapted for carrying out a method for aligning optical components which is another aspect of the present invention. Therefore, the above-described ion beam apparatus enables exploitation of the advantages of the alignment method which are non-iterative fast and reliable alignment of emitter and condenser lens. Thus, time consuming iterative alignment is not longer required in an apparatus according to the first aspect of the present invention.

According to an embodiment of the present invention, the position of the emitter can be adjusted laterally, i.e. the position of the emitter tip can be moved towards or away from a housing of the ion beam apparatus. Typically, the emitter can be positioned by an electric motor. According to another embodiment of the present invention, the emitter is suspended by a gimbal suspension.

According to a further embodiment of the present invention, the position of the aperture can be adjusted within the ion beam apparatus. Thus, the aperture can be aligned with the emitter and the condenser lens.

According to an even further embodiment of the present invention, deflector is arranged downstream the aperture and upstream an objective lens. The deflector is adapted for correcting misalignment of the objective lens. According to still a further embodiment, the deflector is also adapted to correct for astigmatism of the condenser lens and/or the objective lens. Typically, the deflector is formed as a static or quasi-static electrostatic deflector. Thus, specific low bandwidth electronics can be applied for controlling the deflector. As a result, a low noise voltage signal can be applied to the deflector, thus improving the imaging properties of the ion beam apparatus.

According to a second aspect of the present invention, a method for aligning optical components of an ion beam apparatus is provided. The method includes the steps of: emitting an ion beam from an emitter, creating a first image of a beam cross section of the ion beam while applying a first voltage to a condenser lens, creating a second image of the beam cross section of the ion beam while applying a second voltage to the condenser lens, and moving the emitter so that the first and second images are centered with respect to each other.

The above-described alignment method allows high precision alignment of the optical components with respect to each other without an iterative alignment process. The time consumed by the alignment process is considerably reduced, especially because of the non-iterative character of the methods according to the embodiments of the present invention. In principle, alignment of emitter and condenser lens can be accomplished in a single step.

According to an embodiment of the present invention, the ion beam is scanned across an aperture to create the first and second images of the cross section of the ion beam. Thus, the obtained images are comparable independent of the optical components disposed downstream the aperture.

According to a further embodiment of the present invention, calibration data are measured and used for moving the emitter. Thus, automation of the alignment is facilitated and exact alignment can be accomplished in less time.

According to another embodiment of the present invention, an aperture is moved so that the first and/or second image of the beam cross section is centered with respect to the image of a scan area defined by a scan deflector of the ion beam apparatus. Thus, the aperture can be aligned with the emitter and condenser lens.

According to another embodiment of the present invention, a third image of a beam cross section of the ion beam is created while a first voltage is applied to an objective lens, a fourth image of the beam cross section of the ion beam is created while applying a second voltage of the objective lens, and a correction voltage for correcting a misalignment of the objective lens with respect to the optical axis is applied to a deflector. The correction voltage is adjusted so that the third and fourth images are centered with respect to each other. Thus, a misalignment of the objective lens can be corrected.

According to still another embodiment of the present invention, an additional correction voltage for correcting astigmatism of the condenser lens and/or the objective lens is applied to the deflector.

According to a further embodiment of the present invention, the alignment method is carried out by an automated system

### BRIEF DESCRIPTION OF THE DRAWINGS

Some of the above indicated and other more detailed aspects of the invention will be described in the following description and partially illustrated with reference to the figures. Therein:
- Fig. 1: shows an ion beam apparatus according to an embodiment of the present invention.
- Fig. 2A: shows a first embodiment of an ion beam emitter that can be used in an ion beam apparatus according to an embodiment of the present invention.
- Fig. 2B: shows a second embodiment of an ion beam emitter that can be used in an ion beam apparatus according to an embodiment of the present invention.
- Fig. 3: shows a first embodiment of a multi-aperture stage that can be used in an ion beam apparatus according to an embodiment of the present invention.
- Fig. 4: shows a second embodiment of a multi-aperture stage that can be used in an ion beam apparatus according to an embodiment of the present invention.
- Fig. 5: shows the ion beam apparatus of Fig. 1 when being operated.
- Figs. 6A to 6E: illustrate an alignment method according to an embodiment of the present invention.
- Fig. 7: illustrates an alignment method according to a further embodiment of the present invention.
- Fig. 8: shows an ion beam apparatus according to another embodiment of the present invention.

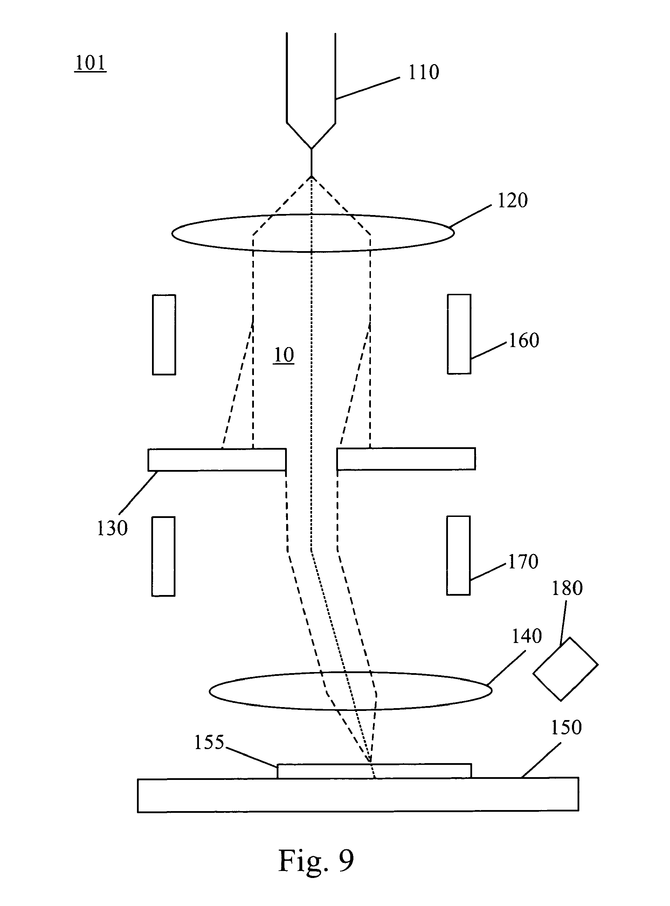

- Fig. 9: shows the ion beam apparatus of Fig. 8 when being operated.
- Figs. 10A to 10E: illustrate an alignment method according to an embodiment of the present invention.
- Fig. 11: illustrates an alignment method according to another embodiment of the present invention.

### DETAILED DESCRIPTION OF THE DRAWINGS

Reference will now be made in detail to the various embodiments of the invention, one or more examples of which are illustrated in the figures. Each example is provided by way of explanation of the invention, and is not meant as a limitation of the invention. For example, features illustrated or described as part of one embodiment can be used on or in conjunction with other embodiments to yield yet a further embodiment. It is intended that the present invention includes such modifications and variations.

According to one aspect of the present invention, an ion beam apparatus is provided. The ion beam apparatus has a movable ion source for producing an ion beam. Furthermore, the ion beam apparatus includes means for producing a first image of a beam cross section of the ion beam at a first voltage of a condenser lens and means for producing a second image of the beam cross section of the ion beam at a second voltage of the condenser lens. Furthermore, the ion beam apparatus includes means for positioning the ion source so that the centers of the first and second images coincide. Typically, the ion beam apparatus includes a scanning means for scanning the ion beam across an aperture to produce the first and second images of the cross section of the ion beam. According to an embodiment of the present invention, the ion beam apparatus further includes means for determining position vectors of the centers of the first and second images, means for calculating a shift vector between the centers of the first and second images, and means for positioning the ion source in accordance with the shift vector. According to another embodiment of the present invention, the ion beam apparatus further includes means for determining alignment calibration data prior, and means for positioning the ion source in accordance with the alignment calibration data. Typically, the ion beam apparatus also includes means for positioning an aperture so that the first and/or second image is centered with respect to the image of a scan area defined by a scanning unit of the ion beam apparatus. According to a further embodiment of the present invention, the ion beam apparatus includes means for producing a third image of a beam cross section of the ion beam at a first voltage of an objective lens, means for producing a fourth image of the beam cross section of the ion beam at a second voltage of the objective lens, and means for applying an alignment correction voltage to a deflector so that the centers of the third and fourth images coincide. According to an optional embodiment of the present invention, the ion beam apparatus includes means for producing a third image of a beam cross section of the ion beam at a first voltage of the deflector, means for producing a fourth image of the beam cross section of the ion beam at a second voltage of the deflector causing a first shift of the fourth image with respect to the third image, means for producing a fifth image of the beam cross section of the ion beam at a third voltage of the deflector causing a second shift of the fifth image with respect to the third image, and means for applying an alignment correction voltage to the deflector so that the first and second image shifts have equal absolute values but opposite signs. According to still another embodiment of the present invention, the ion beam apparatus further includes means for applying an astigmatism correction voltage to the deflector for correcting astigmatism of the objective lens and/or the condenser lens. Typically, the above described means are included in an automated system.

According to a further aspect of the present application, a method for aligning components of an ion beam apparatus is provided. The method includes steps of producing an ion beam by means of a movable ion source, producing a first image of a beam cross section of the ion beam at a first voltage of a condenser lens, and producing a second image of the beam cross section of the ion beam at a second voltage of the condenser lens, wherein producing the first and second images includes the step of scanning the ion beam across an aperture by means of a scanning unit disposed between the condenser lens and the aperture. Finally, the method according to the present aspect of the invention includes the step of positioning the movable ion source so that the centers of the first and second images coincide. Typically, the ion source is moved in at least one lateral direction of the ion beam apparatus. More typically, the ion source is moved by an electric motor. According to another embodiment of the present invention, the ion source is gimballed. According to a further embodiment of the present invention, the method includes the step of moving the aperture. According to an even further embodiment of the present invention, a misalignment of an objective lens is corrected by a deflector disposed between the aperture and the objective lens. Typically, also astigmatism of the condenser lens and/or the objective lens is corrected by the deflector. More typically, the deflector will be operated in a static or quasi-static mode.

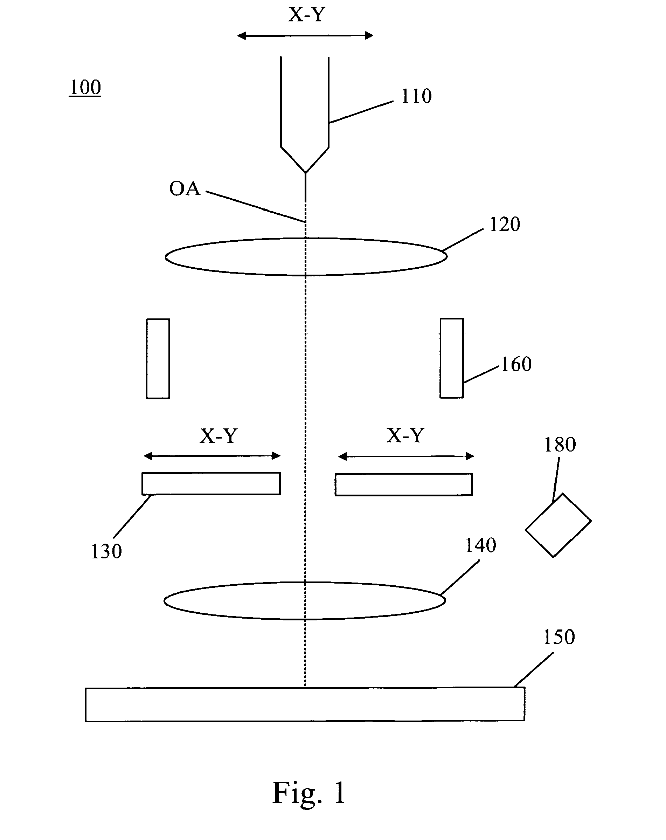

Fig. 1 shows an ion beam apparatus 100 according to an embodiment of the present invention. The ion beam apparatus 100 includes a movable ion source 110 and a condenser lens 120 according to conventional art. Downstream, as seen in the direction of the ion beam produced by source 110, of condenser lens 120, an aperture 130 is disposed. In the present embodiment, aperture 130 is movable but it should be noted that the present invention may also be carried out with a stationary aperture. Downstream aperture 130, an objective lens 140 for focusing an ion beam is provided. A scanning unit 160 is disposed between the condenser lens 120 and the aperture 130. Scanning unit 160 is adapted to scan an ion beam across the aperture 130. Finally, ion beam apparatus 100 has a detector 180 for detecting secondary particles generated by the ion beam impinging on a specimen.

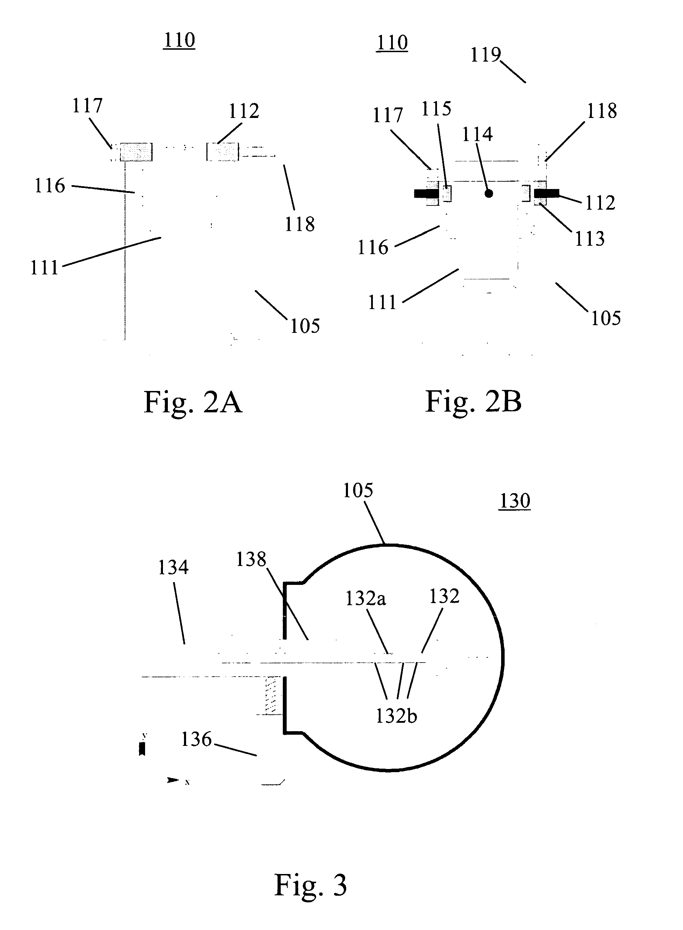

Typically, the ion source 110 is an ion beam source such as a liquid metal ion beam source (LMIS) or a liquid metal alloy ion beam source (LMAIS). As is indicated in Fig. 1, the source 110 is movably mounted so that it can be moved in X- and Y-direction, i.e. in a plane normal to the optical axis OA of the ion beam apparatus 100. A detailed view of a first embodiment of movable source 110 is shown in Fig. 2A. Therein, the source 110 includes an emitter tip 111 from which the ions, e.g. ions of a liquid metal ion source (LMIS), are emitted. The emitter tip 111 is mounted to a bearing 112 holding the emitter. As shown in Fig. 2A, a membrane bellow 116 isolates the bearing 112 from the inside of the column housing 105 in a vacuum-tight manner. The positioning mechanism of the source 110 is located outside the column vacuum and includes an alignment screw 118 and a spring 117. The alignment screw 118 is disposed at a lateral end of source bearing 112 and the spring 117 is disposed at the opposite lateral end of source bearing 112. Thus, source bearing 112 is spring-loaded and abuts against alignment screw 118. An operator may now manipulate alignment screw 118 to move source bearing 112 and, accordingly, emitter tip 111 with respect to the axis defined by alignment screw 118 and spring 117. Thus, the position of ion source 110 can be adjusted along the axis defined by alignment screw 118 and spring 117, e.g. the X-axis. Although not shown in Fig. 2A, the source 110 may include a further alignment screw and spring which are oriented normal to both the X-axis defined by alignment screw 118 and spring 117 and the optical axis OA. Thus, the further alignment screw and spring will together define a Y-axis in which the source bearing 112 is similarly movable. With these two pairs of alignment screws and springs, the source bearing 112 is movable independently in X- and Y-direction, i.e. the position of ion source 110 can be adjusted in a plane which is more or less normal to the optical axis of ion beam apparatus 100.

An alternative embodiment of ion source 110 is shown in Fig. 2B. Therein, emitter tip 111 is gimballed within the column. Similar to the embodiment shown in Fig. 2A, a membrane bellow 116 isolates the emitter tip 110 in a vacuum-tight manner from the source gimbal suspension. The gimbal suspension includes a Y-axis frame 113 which is fixed to column housing 105 by a Y-axis bearing 112. Inside Y-axis frame 113, an X-frame 115 is suspended by means of an X-axis bearing 114. At one lateral side, the Y-frame 112 is spring-loaded by a spring 117 whereas it abuts against an alignment screw 118 at its opposite lateral side. However, in the gimballed source bearing, the spring 117 as well as alignment screw 118 act upon the gimbal suspension in a direction essentially parallel to the optical axis OA. As a result, emitter tip 111 rotates around an axis which is normal to the optical axis and located outside and above emitter tip 111. For a detailed explanation of a gimbal suspension for an ion source, reference is made to EP 0 296 385 which is hereby incorporated by reference. Since the gimbal suspension of the emitter typically uses ball bearings it has only low friction. Therefore, relatively low torque is required so that a standard electric motor 119 can be used for driving the alignment screw. Also, the use of grease in the movable source can be avoided. Furthermore, in both of the above described embodiments a reduction gear may be provided to allow fine adjustment of the alignment screw. In addition, mechanical stress on the membrane bellow due to lateral motion is avoided.

Fig. 3 shows an embodiment of an aperture that can be used in an ion beam apparatus according to an embodiment of the present invention. Therein, the aperture 130 is a multi-aperture stage 132 including a plurality of apertures 132a, 132b. The apertures 132a, 132b may differ in size or may have the same size. Furthermore, a first electric drive 134 including an alignment screw is adapted to move the aperture stage 132 along the X-axis. Similarly, a second electric drive 136 is adapted to move the aperture stage 132 along the Y-axis. Thus, the multi-aperture stage 132 can be adjusted in the X-Y-plane, i.e. in a plane substantially normal to the optical axis of the ion beam apparatus. As shown in Fig. 3, the first and second electric drives 134, 136 are located outside the column housing 105. Therefore, a membrane bellow 138 is provided for establishing a vacuum-tight seal.

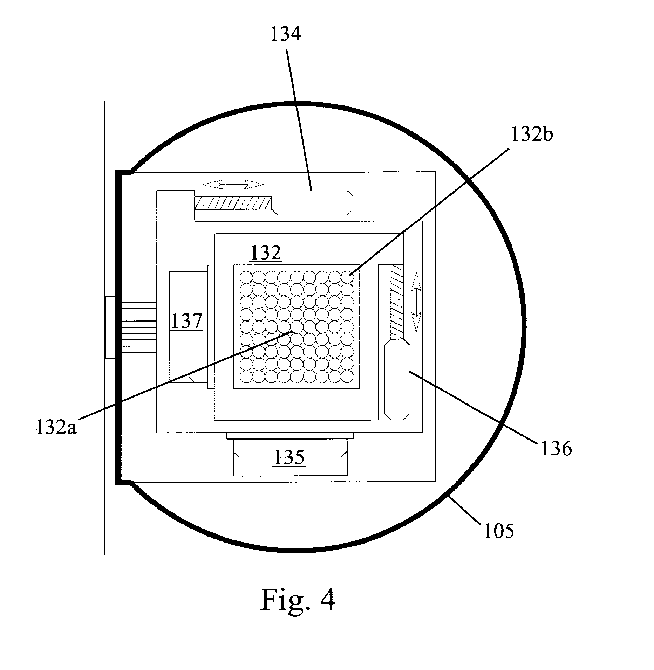

Fig. 4 shows an alternative embodiment of an aperture that can also be used in an ion beam apparatus according to an embodiment of the present invention. Therein, a multi-aperture stage 132 includes a plurality of apertures 132a, 132b. One of the apertures 132a is positioned to be used as a beam limiting aperture in the ion beam apparatus 100. However, the multi-aperture stage 132 according to the embodiment shown in Fig. 4 is fully disposed within the column housing 105. In other words, the X-axis drive 134 and the Y-axis drive 136 are also located within the column housing. Thus, the vacuum-tight mechanical leadthrough of the embodiment shown in Fig. 3 is avoided. As a result, the vacuum-tightness of the ion beam apparatus can be improved. However, the drives 134, 136 for the multi-aperture stage 132 have to fulfill vacuum requirements. Typically, the X-axis and Y-axis drives 134, 136 are formed as linear piezoelectric drives. However, any other kind of vacuum-compatible drive may also be used. Furthermore, position encoders 135, 137 are provided to detect the position of the aperture stage 132 along the X-axis and Y-axis. This design of the multi-aperture stage 132 allows large travel ranges in X- and Y-direction. Therefore, a large number of apertures, e.g. over 80 apertures, can be provided on multi-aperture stage 132. The apertures 132a, 132b may vary in size so that optimum aperture sizes can be provided for different operating conditions. Furthermore, redundant apertures, i.e. apertures of the same size, can be provided so that the maintenance cycle of the aperture stage is considerably extended. Because the encoders 135, 137 are typically directly fixed to the multi-aperture stage 132, the effects of thermal drift and a positioning error resulting therefrom are reduced. As a consequence, repeatability is improved so that automated aperture selection and positioning based on initial calibration is enabled. In addition, the calibration frequency can be reduced. Moreover, the above-described embodiment of the multi-aperture stage is less sensitive to vibrations compared to the aperture rod shown in Fig. 3 and only an electrical feedthrough is required instead of a mechanical leadthrough. Aside from the vacuum sealing problem, an electrical feedthrough is not subject to mechanical stress and, typically, more reliable than a mechanical leadthrough.

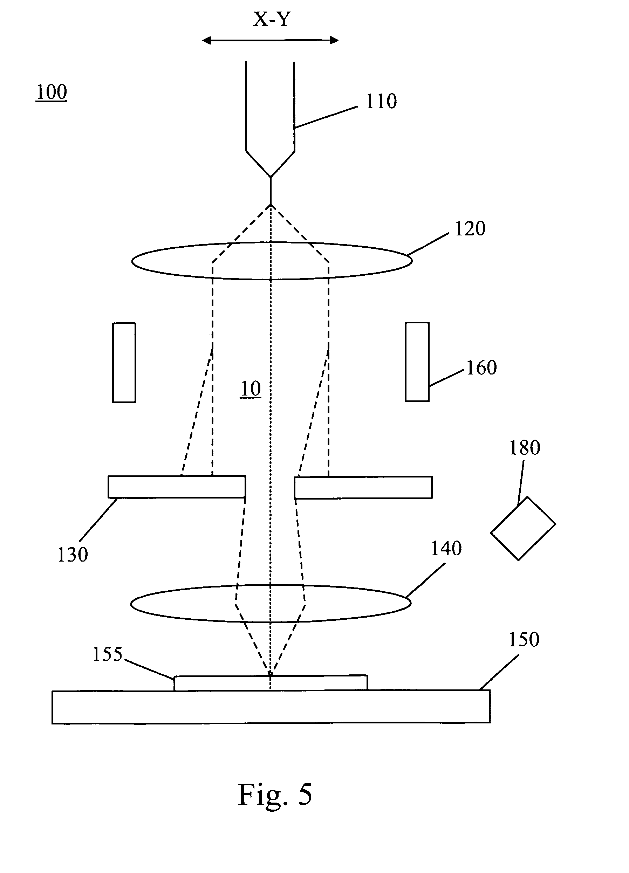

Next, the operation of the ion beam apparatus 100 is described with reference to Fig. 5. Therein, it is shown that an ion beam 10 is produced by ion source 110. Then, the ion beam 10 is condensed by condenser lens 120. The scanning unit 160 scans the electron beam across aperture 130 and the detector 180 detects secondary particles produced when the ion beam 10 impinges onto a specimen 155. A scan area is defined for scanning unit 160, wherein ion beam 10 is then raster scanned across the scan area. Thus, an image of the cross section of ion beam 10 in the aperture plane can be recorded by means of detector 180. Next, it will be described how this imaging of the beam cross section can be utilized for non-iterative alignment of the optical components of the ion beam apparatus.

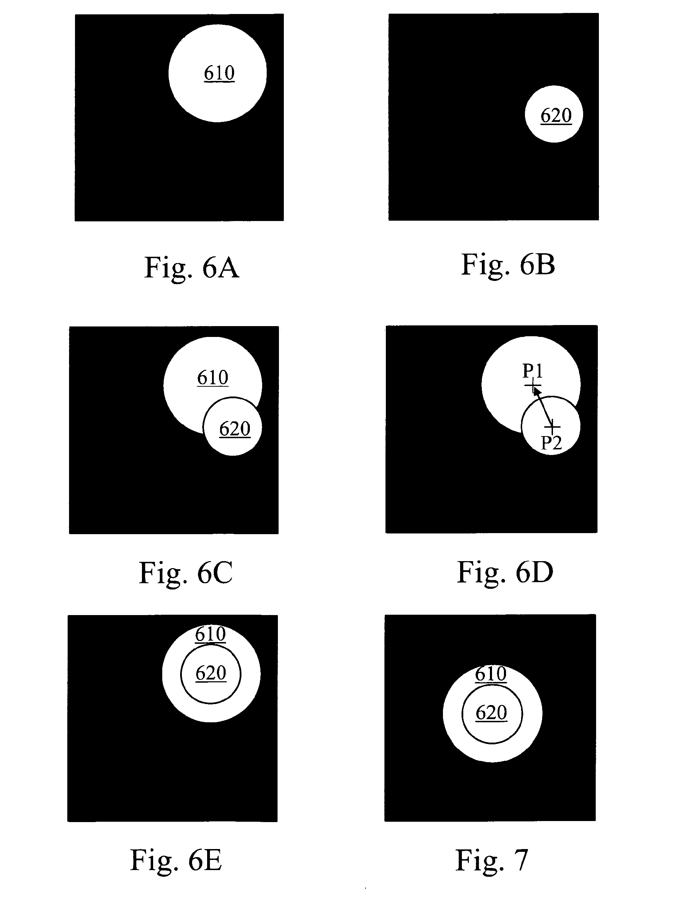

Fig. 6A shows an example of such a recorded raster scanned image. In principle, the image shows a bright spot 610 corresponding to the cross section of the ion beam 10 at the plane of aperture 130. The location of spot 610, i.e. of the center P1 of image 610, depends on the relative alignment of the ion source 110, the condenser lens 120, and the aperture 130 with respect to each other as well as on the voltage of the condenser lens 120. Therefore, it is assumed that the first image 610 is recorded at a first voltage U_{c1} of the condenser lens 120. Next, a second image 620 of the beam cross section is recorded at a second voltage U_{c2} of the condenser lens. The second image 620 is shown in Fig. 6B. In the present example, the second condenser voltage U_{c2} is higher than the first condenser voltage U_{c1}. Therefore, the ion beam 10 is more condensed at the second voltage U_{c2} and, accordingly, the size of the second image 620 is smaller than the size of the first image 610. Furthermore, since the ion source 110 and the condenser lens 120 are not exactly aligned with respect to each other, i.e. since condenser lens 120 is not centered with respect to the optical axis, not only the size of the image changes but also the center P2 of the second image 620 is shifted with respect to the center P1 of the first image. This can be seen from Fig. 6C which shows a superposition of the first and second images 610, 620. To align ion source 110 and condenser lens 120, the position of the movable ion source 110 is adjusted so that the centers P1, P2 of the first and second images 610, 620 coincide (see Fig. 6D). The final result of the alignment procedure is shown in Fig. 6E. Since the source 110 and the condenser lens 120 are aligned with respect to each other, varying the condenser voltage only changes the size of the beam cross sections 610, 620 but does not lead to a shift in position.

An alignment method according to one of the above-described embodiments of the present invention allows high precision alignment of the optical components with respect to each other. Simultaneously, the time consumed by the alignment process is considerably reduced, especially because of the non-iterative character of the methods according to the embodiments of the present invention.

However, it can be seen from Fig. 6E that the first and second images 610, 620 are not centered with respect to the image, i.e. with respect to the scan area defining the image. This is due to the fact that aperture 130 is misaligned with respect to the aligned source and condenser lens. For a correctly aligned aperture 130, the first and second images 610, 620 will be centered within the image of the scan area. In other words, the centers P1, P2 of the first and second images 610, 620 will then coincide with the center of the imaged scan area. If aperture 130 is movably mounted within column 105, the aperture misalignment may therefore be corrected by adjusting the position of aperture 130 so that the image of the beam cross section is centered within the recorded image. The resulting centered image of the beam cross section(s) is shown in Fig. 7 in which the first and second images 610, 620 are centered within the recorded image.

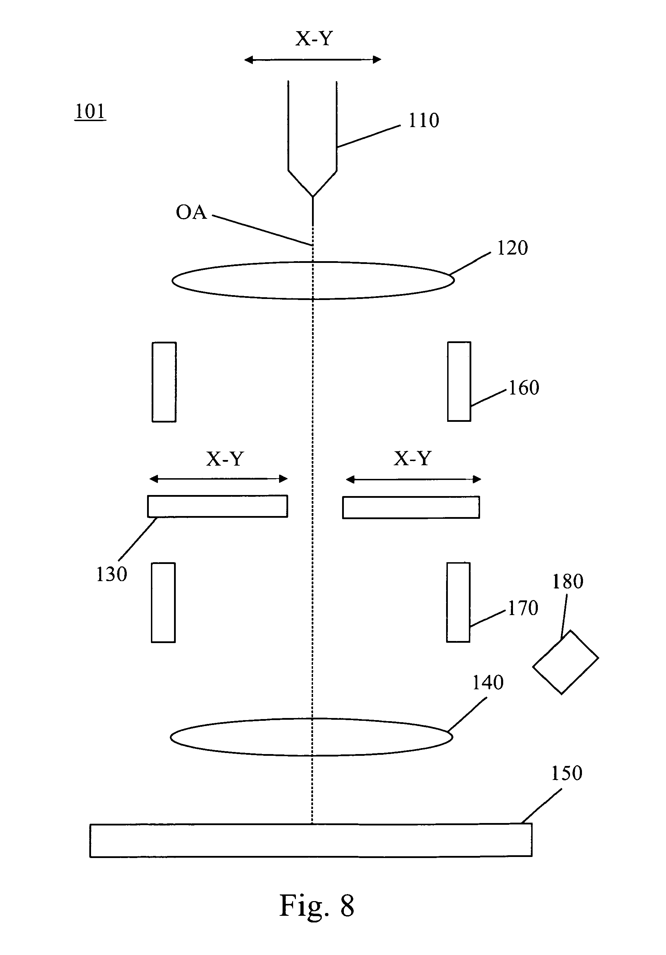

A further embodiment of an ion beam apparatus 101 according to the present invention is shown in Fig. 8. The basic configuration of apparatus 101 is similar to the embodiment shown in Fig. 1. However, the ion beam apparatus 101 further includes a deflector 170 disposed between the aperture 130 and the objective lens 140. Deflector 170 is adapted to correct a misalignment of objective lens 140. For this purpose, deflector 170 is typically formed as a static or, at least, quasi-static deflector, i.e. a deflector having a very low cutoff frequency. Accordingly, deflector 170 is adapted for static or quasi-static voltages in contrast to the rapidly oscillating voltages of a scanning unit. Therefore, low bandwidth electronics can be used for controlling deflector 170. Due to the low bandwidth, the noise induced by such electronics is relatively small compared with the noise generated in the high bandwidth electronics required by a scanning unit. Furthermore, deflector 170 is typically formed as an electrostatic deflector adapted for high voltages in the range above 200 V. Thus, deflector 170 is adapted even for ions having high mass.

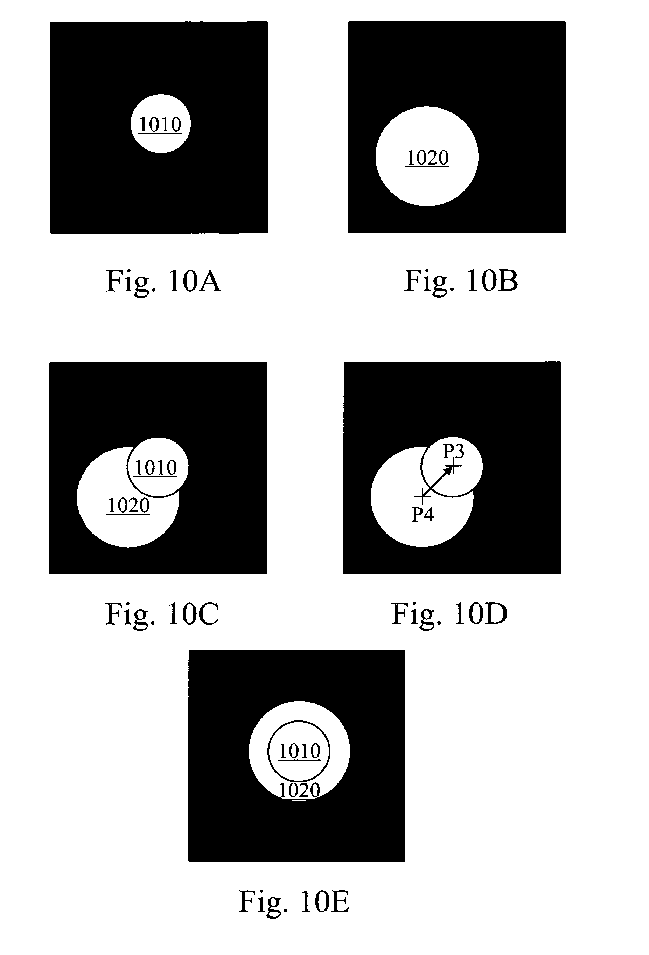

Next, the operation of ion beam apparatus 101 is explained with reference to Figs. 10A to 10E. Therein, the ion source 110, the condenser lens 120, and the aperture 130 have been already aligned by an alignment method according to an embodiment of the present invention. In particular, source 110, condenser lens 120, and aperture 130 have been aligned with a method described above with reference to Figs. 6 and 7. During alignment of the source 110, condenser lens 120, and aperture 130, the deflector 170 is idle, i.e. the deflector 170 is operated so that it does not deflect ion beam 10. After alignment of the source 110, condenser lens 120, and aperture 130, a third image 1010 of the ion beam 10 is recorded at a first voltage Uₒ₁ of the objective lens 140 as shown in Fig. 10A. The spot size of image 1010 is determined by the voltage Uₒ₁ of the objective lens 140. In the present example, the third image 1010 is centered with respect to the recorded image. Next, a fourth image 1020 of the ion beam 10 is recorded at a second voltage Uₒ₂ of the objective lens 140 which is different to the first voltage Uₒ₁. Due to the voltage difference, the focus of the ion beam 10 changes and, accordingly, the spot size. Due to the misalignment of objective lens 140 with respect to the optical axis, however, the center P4 of the fourth image 1020 shifts with respect to the center P3 of the third image 1010. This can be seen from Fig. 10C which shows a superposition of the third and fourth images 1010, 1020. Other than ion source 110 and aperture 130, objective lens 140 is not movable. Therefore, objective lens 140 cannot be aligned by adjusting its position with respect to the optical axis. However, an alignment correction voltage U_{align} can be applied to deflector 170 to shift the optical axis so that it passes through the center of objective lens 140. Although the optical axis is in fact tilted and not only shifted by deflector 170, the angles involved are so small that the effect is almost the same and deviations are negligible. The final result of the alignment procedure is shown in Fig. 10E. Since the optical axis passes through the center of the objective lens, varying the voltage of the objective lens only changes the spot size 1010, 1020 but does not longer lead to a shift in position.

By aligning the objective lens 140 according to the above-described method, aberrations can be considerably reduced. Furthermore, deflector 170 can be used as a stigmator to correct the astigmatism of the lens system, i.e. the astigmatism of condenser lens 120 and/or objective lens 140. In conventional ion beam apparatus, the scan deflectors (not shown) for raster scanning the specimen 155 are also used as stigmators. While the scan requires a highfrequency sawtooth voltage, stigmation requires static or, at least, quasi-static voltages. Therefore, it is advantageous to transfer the stigmation function from the scanning unit to deflector 170. Thus, the scan electronics can be simplified since the static stigmation voltage is not longer required. Furthermore, the scan electronics can utilize the full available voltage range for the scan without allocating resources for the static stigmation voltage. Simultaneously, the stability of the stigmation voltage can be improved due to reduced noise since a low bandwidth electronics can be used for the stigmation voltage.

Although in the above described method for correcting a misalignment of the objective lens a variation in the voltage of the objective lens 140 was used to shift the focus of the electron beam, it should be understood that also other equivalent means may be used therefor. Particularly, also a variation of the acceleration voltage may serve to provide third and fourth images 1010, 1020. Furthermore, it should be understood that the above described method for correcting a misalignment of the objective lens may also be applied even without previous alignment of the aperture, for example in cases where the aperture 130 cannot be moved within column housing 105. In this case, the third and fourth images 1010, 1020 will not be centered with respect to the image of the scan area.

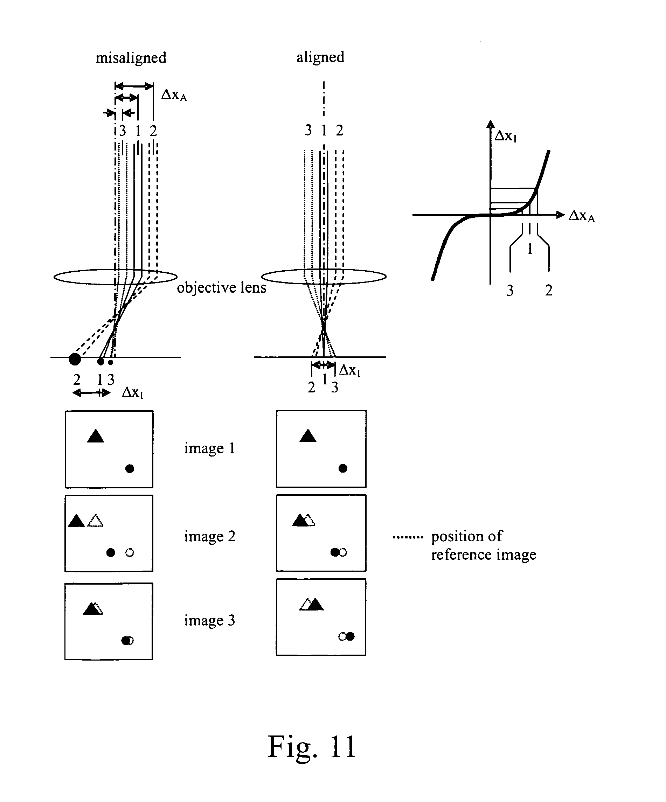

An alternative method for correcting a misalignment of the objective lens will now be described with reference to Fig. 11. Therein, the alignment method will be explained first with respect to the center column of Fig. 11 showing the case of a correctly aligned objective lens. According to this alignment method, a first image (image 1) is recorded with the ion beam being centered with respect to the objective lens. Next, deflector 170 is used to shift ion beam to the right by a displacement +Δx_{A} with respect to the centered position. This shift of the ion beam results in a shift -Δx₁ to the left of the recorded image (image 2). Subsequently, deflector 170 is used to shift ion beam to the left by a displacement -Δx_{A} with respect to the centered position of the ion beam. This shift of the ion beam results in a shift +Δx₁ to the right of the recorded image (image 3). Since the objective lens is correctly aligned with respect to the optical axis, the absolute values |Δx₁| of the image shifts are equal but have opposite signs. In contrast, the case of a misaligned objective lens is shown on the left-hand side of Fig. 11. Three images are recorded in the same manner as described above. However, the shifts ± Δx_{A} result in images different from those obtained with a correctly aligned objective lens. A comparison of shifted images 2 and 3 reveals that both images are shifted in the same direction, i.e. the image shifts have the same sign, but have different absolute values. This can be explained by the aberration errors of the objective lens. As it shown in the little inset on the right hand-side of Fig. 11, the aberration errors Δx₁ of the objective lens are of third order and, accordingly, antisymmetric with respect to zero. Therefore, for a correctly aligned objective lens the beam shifts Δx_{A} cause image shifts Δx₁ of identical absolute value but opposite sign. If, however, the objective lens is misaligned (which case is shown in the inset) the beam shifts Δx_{A} cause image shifts Δx₁ of different absolute value and, most probably, opposite sign. Thus, a misalignment of the objective lens can be detected from the comparison of the shifted images with respect to the reference image. Next, the misalignment of the objective lens may be corrected by means of a biasing field produced by the deflector 170. In fact, the correction will be similar to the measures described with respect to the alternative alignment method described above. Of course, also in this method a biasing field for correcting astigmatism of objective and/ or condenser lens may be applied in addition.

The alignment methods according to the above-described embodiments can be further improved if calibration data are determined prior to the alignment process. The calibration data can be recorded well before the alignment of the optical components, stored in a memory, a hard drive or the like, and then used during the actual alignment. The calibration data may include a relation between a source shift and an image shift, a relation between an aperture shift and an image shift, a relation between an alignment correction voltage and an image shift. The calibration data may further include a relation between a condenser voltage variation and a spot size variation, a relation between a condenser voltage variation and an image shift, a relation between an objective voltage variation and an image shift, a relation between an objective voltage variation and a spot size variation, a relation between an acceleration voltage variation and an image shift, and a relation between an acceleration voltage variation and a spot size variation. From the calibration data and the detected image shifts, correct positions of the source and aperture as well as the correct alignment correction voltage can be obtained. This process may be automated. For example, an image processing program can determine the centers P1, P2, P3, P4 of the first, second, third, and fourth images. Position vectors of the centers as well as shift vectors for shifting the centers as described above can be calculated from these data. The calculated shifts can be translated into shifts of the source, aperture and/or an alignment correction voltage. The positioning mechanisms of the source and aperture, e.g. linear piezoelectric drives, can be controlled based on the determined shift data. The whole process can be controlled by an automated system, e.g. a computer which has been programmed accordingly.

Thus, a fully automated non-iterative alignment method can be implemented in an ion beam apparatus according to the present invention. Such an alignment method allows high precision alignment of the optical components with respect to each other. Simultaneously, the time consumed by the alignment process is considerably reduced, especially because of the non-iterative character of the methods according to the embodiments of the present invention.

Having thus described the invention in detail, it should be apparent for a person skilled in the art that various modifications can be made in the present invention without departing from the spirit and scope of the following claims.

## Claims

1. An ion beam apparatus (100), comprising
a movable ion source (110),
a condenser lens (120),
an aperture (130), and
a scanning unit (160) disposed between the condenser lens (120) and the aperture (130), said scanning unit (160) being adapted to scan an ion beam (10) across the aperture (130).

2. The ion beam apparatus (100) according to claim 1, wherein the ion source (110) is movable in at least one lateral direction of the ion beam apparatus (100).

3. The ion beam apparatus (100) according to claim 1 or 2, wherein the ion source (110) is movable by an electric motor (119).

4. The ion beam apparatus (100) according to any of the preceding claims, wherein the ion source (110) is gimballed.

5. The ion beam apparatus (100) according to any of the preceding claims, wherein the aperture (130) is a movable aperture (130).

6. The ion beam apparatus (100) according to any of the preceding claims, further comprising a deflector (170) disposed between the aperture (130) and an objective lens (140), the deflector (170) being adapted to correct a misalignment of the objective lens (140).

7. The ion beam apparatus (100) according to claim 6, wherein the deflector (170) is further adapted to correct for astigmatism of the condenser lens (120) and/or the objective lens (140).

8. The ion beam apparatus (100) according to claim 6 or 7, wherein said deflector (170) is a static or quasi-static electrostatic deflector.

9. A method for aligning components of an ion beam apparatus according to any of the preceding claims, comprising the steps of:
(a) producing an ion beam (10) by means of an ion source (110),
(b) producing a first image (610) of a beam cross section of the ion beam (10) at a first voltage (U_{c1}) of a condenser lens (120),
(c) producing a second image (620) of the beam cross section of the ion beam (10) at a second voltage (U_{c2}) of the condenser lens (120), and
(d) positioning the ion source (110) so that the centers (P1, P2) of the first and second images (610, 620) coincide.

10. The alignment method according to claim 9, wherein the ion beam (10) is scanned across an aperture (130) to produce the first and second images (610, 620) of the cross section of the ion beam (10).

11. The alignment method according to claim 9 or 10, further comprising the steps of determining position vectors of the centers (P1, P2) of the first and second images (610, 620), calculating a shift vector between the centers (P1, P2) of the first and second images (610, 620), and positioning the ion source (110) in accordance with the shift vector.

12. The alignment method according to any of claims 9 to 11, further comprising the steps of determining alignment calibration data prior to step (a), and positioning the ion source in accordance with the alignment calibration data.

13. The alignment method according to any of claims 10 to 12, further comprising the step of
(e) positioning an aperture (130) so that the first and/or second image (610, 620) is centered with respect to the image of a scan area defined by a scanning unit (160) of the ion beam apparatus.

14. The alignment method according to any of claims 9 to 13, further comprising the steps of
(f) producing a third image (1010) of a beam cross section of the ion beam (10) at a first voltage (Uₒ₁) of an objective lens (140),
(g) producing a fourth image (1020) of the beam cross section of the ion beam (10) at a second voltage (Uₒ₂) of the objective lens (140), and
(h) applying an alignment correction voltage to a deflector (170) so that the centers (P3, P4) of the third and fourth images (1010, 1020) coincide.

15. The alignment method according to any of claims 9 to 13, further comprising the steps of
(f) producing a third image of a beam cross section of the ion beam (10) at a first voltage of the deflector (170),
(g) producing a fourth image of the beam cross section of the ion beam (10) at a second voltage of the deflector (170) causing a first shift (+Δx₁)of the fourth image with respect to the third image,
(h) producing a fifth image of the beam cross section of the ion beam (10) at a third voltage of the deflector (170) causing a second shift (-Δx₁)of the fifth image with respect to the third image,
(i) applying an alignment correction voltage to the deflector (170) so that the first and second image shifts (+Δx₁, -Δx₁) have equal absolute values but opposite signs.

16. The alignment method according to claim 14 or 15, further comprising the step of applying an astigmatism correction voltage to the deflector (170) for correcting astigmatism of the objective lens (140) and/or the condenser lens (120).

17. The alignment method according to any of claims 9 to 16, wherein the method steps are carried out by an automated system.
